# EUROPÄISCHE PATENTSCHRIFT

(11) **EP 2 770 434 B1**
(45) Veröffentlichungstag und Bekanntmachung des Hinweises auf die Patenterteilung: **14.09.2016**
(21) Anmeldenummer: 13000867.5
(22) Anmeldetag: 21.02.2013
(51) Int. Cl.: G06F 11/22

(54) **Verfahren zur Durchführung einer Inventarisierung der an ein Steuergeräte-Testsystem angeschlossenen Hardware-Komponenten**
Method for creating an inventory of the hardware components connected to a test system of a control device
Procédé de réalisation d'un inventaire des composants matériels rattachés à un système de test d'appareils de commande

(43) Veröffentlichungstag der Anmeldung: 27.08.2014
(73) Patentinhaber: dSPACE digital signal processing and control engineering GmbH, 33102 Paderborn (DE)
(72) Erfinder: Brehm, Thorsten, 33102 Paderborn (DE); Köhl, Susanne, 33098 Paderborn (DE); Paule, Jürgen, 71157 Hildrizhausen (DE); Klahold, Jürgen, 33034 Brakel (DE); Diener, Claus, 85283 Wolnznach (DE)
(74) Vertreter: Cohausz Hannig Borkowski Wißgott

(56) Entgegenhaltungen:
- US-A1- 2004 030 880
- US-A1- 2008 154 957

## Beschreibung

Die Erfindung betrifft ein Verfahren zur Durchführung einer Inventarisierung der an ein Steuergeräte-Testsytem angeschlossenen Hardware-Komponenten, wobei mit dem Testsystem Steuergeräte in einer vom Testsystem mittels eines Modells simulierten Umgebung testbar sind und wobei das Testsystem zumindest einen Rechner und Hardware-Komponenten umfasst, die mittels wenigstens eines Netzwerks miteinander verbunden sind.

Testsysteme zur Durchführung von Steuergerätetests sind im Stand der Technik bekannt. Getestet werden können beispielsweise Steuergeräte für Kraftfahrzeuge ebenso wie für andere Vorrichtungen, beispielsweise Fertigungsautomaten, wie Roboter oder auch andere Beförderungsmittel, wie beispielsweise Flugzeuge. Alle diese Vorrichtungen haben im Wesentlichen gemeinsam, dass diese zur einwandfreien Funktion wenigstens ein Steuergerät aufweisen, welches Umweltdaten oder Daten von mit der Umwelt interagierenden Sensoren erfasst und hierauf reagiert.

Um die (einwandfreie) Funktion von Steuergeräten zu überprüfen, wird auf ein Verfahren zurückgegriffen, welches auch als "Hardware-in-the-loop" bezeichnet wird und welches im Wesentlichen besagt, dass ein konkret real existierendes elektronisches Steuergerät getestet wird, wofür dieses Steuergerät in ein Testsystem integriert wird, welches wenigstens einen Rechner umfasst, der eine Testumgebung simuliert, beispielsweise anhand eines darin gespeicherten und ausgeführten Modells sowie auch weiterhin Hardwarekomponenten umfasst, die miteinander zum Zweck der Kommunikation verbunden sind, was beispielsweise über wenigstens ein Netzwerk, insbesondere ein als Bus ausgebildetes Netzwerk erfolgen kann.

Typische Hardwarekomponenten, zu denen auch das zu testende Steuergerät selbst gehört, können beispielsweise Kabelbäume sein, mechatronische Komponenten, Echtlasten sowie sonstige Elektroniken, die zur Durchführung eines individuellen Tests benötigt werden, z.B. A/D-Wandler, Schnittstellen etc.

Insbesondere durch Echtlasten kann berücksichtigt werden, dass bei einem durchzuführenden Test gegebenenfalls bestimmte Umweltbedingungen, wie äußere Einflüsse auf ein Steuergerät nicht durch ein Modell in einer Simulation bereitgestellt werden, so dass in einem solchen Fall tatsächliche reale Lasten, zum Beispiel Aktoren, Sensoren oder sonstige Datengeber, insbesondere konkrete Hardwarekomponenten eines Systems, in welches ein Steuergerät bei seiner späteren Funktion eingebunden ist, an das Testsystem angeschlossen werden.

Ein konkretes Beispiel aus dem Kraftfahrzeugbereich ist die Anbindung einer Drosselklappe an das Testsystem, da diese ein simulativ nur schwer bis gar nicht erfassbares Verhalten aufweist. Ebenso können andere Echtlasten, wie z.B. ein Lenksystem oder ein Gas-, Brems- oder Kupplungspedal angeschlossen werden, auch wenn diese grundsätzlich simulierbar sind.

Ein konkreter Test kann beispielsweise vorsehen, dass die Eingänge eines Steuergerätes mit Sensordaten aus einem Modell stimuliert werden oder alternativ, sofern solche Sensordaten nicht aus einem Modell durch Simulation erhalten werden können, durch Daten aus den eingangs genannten realen Komponenten stimuliert werden.

Die Reaktion eines zu testenden Steuergerätes auf solche Daten kann durch das Rücklesen von Ausgangsdaten des Steuergerätes in das Modell beziehungsweise den das Modell ausführenden Rechner erfolgen und somit überprüft, also getestet werden. Vorteilhaft ist es, dass ein solches Testsystem im Wesentlichen in Echtzeit dem zu testenden Steuergerät eine Umgebung simulieren kann, so dass das Steuergerät getestet werden kann, als wäre es tatsächlich in derjenigen Vorrichtung verbaut, in der es später zum Einsatz kommen soll. Um Echtzeitfähigkeit zu ermöglichen, können Simulationszyklen eine bevorzugte Dauer von weniger als 1 ms aufweisen.

Eventuelle Fehler eines Steuergerätes können mittels eines solchen Testsystems frühzeitig erkannt, insbesondere durch wiederkehrende Simulationsabläufe reproduziert werden und die Beseitigung von aufgefundenen Fehlern, insbesondere durch Wiederholung der Testabläufe, die zum Fehler geführt haben, verifiziert werden.

Für die einwandfreie Funktion eines Testsystems ist es wesentlich, dass auch die Konfiguration des Testsystems korrekt durchgeführt wurde. Eine solche Konfiguration, das heißt die Zusammenstellung der einzelnen Hardware-Komponenten des Testsystems wird im Wesentlichen von Menschenhand durchgeführt, so dass sich eine Fehleranfälligkeit des Testsystems selbst auch dadurch ergibt, dass bei der Konfiguration falsche Hardwarekomponenten in das Testsystem integriert wurden.

Soll beispielsweise ein bestimmter Test, das heißt eine bestimmte Umweltbedingung oder Interaktion eines Steuergerätes mit der simulierten Umwelt getestet werden, so kann ein Fehler schon dadurch erzeugt werden, dass eine Hardwarekomponente ausgewählt wird, die nicht geeignet ist, um für die gewünschte zu simulierende Umweltbedingung die dafür benötigten Daten zu liefern.

Soll beispielsweise mittels eines Testsystems eine in einem Steuergerät implementierte Drosselklappensteuerung eines 6-Zylinder-Motors überprüft werden, so kann dieser Test ersichtlich nicht korrekt durchgeführt werden, wenn versehentlich durch eine das Testsystem konfigurierende Person als Echtlast eine 4-Zylinder-Drosselklappe an das Testsystem angeschlossen wird.

Die Fehleranfälligkeit eines von Hand konfigurierten Testsystems kann beispielsweise reduziert werden, wenn eine Möglichkeit der Inventarisierung der an ein Steuergeräte-Testsystem angeschlossenen Hardwarekomponenten realisiert wird, da so aufgrund einer solchen Inventarisierung jederzeit eine Information zur Verfügung steht, welche konkreten Hardwarekomponenten an das jeweilige Testsystem angeschlossen sind.

Bislang sieht eine eventuelle Inventarisierung im Stand der Technik lediglich vor, dass aufgrund der händischen Konfiguration der einzelnen Hardwarekomponenten in einem Testsystem auch eine manuelle Erfassung der jeweiligen Komponenten im Testsystem erfolgt. Auch dies birgt jedoch wiederum die Gefahr von Fehlern aufgrund des menschlichen Einflusses Darüber hinaus ist eine manuelle Erfassung zeitlich aufwändig und kostenintensiv.

Die Veröffentlichung US-A-2004/0030880 entspricht dem Präambel des unabhängigen Anspruchs 1.

Die Aufgabe der Erfindung ist es, ein Verfahren zur Inventarisierung der an ein Steuergeräte-Testsystem angeschlossenen Hardwarekomponenten bereitzustellen, das im Wesentlichen menschliche Einflüsse als Fehlerquelle ausschließt beziehungsweise eindeutig identifiziert und so zu einer größeren Prozesssicherheit und auch einer grundsätzlichen Dokumentationsfähigkeit beiträgt.

Die Aufgabe wird durch die in dem unabhängigen Patentanspruch 1 definierten Merkmale gelöst. Vorteilhafte Weiterbildungen sind in den abhängigen Patentansprüchen angegeben.
Figur 1 zeigt in einer insgesamten Darstellung in der Form eines Blockdiagramms ein Testsystem zur Durchführung eines Tests eines Steuergerätes.
Figur 2 zeigt eine zweite Ausführungsform.
Figur 3 zeigt eine beispielhafte Ausführung eines Gateways.

Bevorzugt soll ein Verfahren bereitgestellt werden, das automatisch eine Inventarisierung erstellt und bevorzugter Weise auch die Möglichkeit erschließt Konfigurationsprüfungen, Konsistenzprüfungen und Dokumentationen durchzuführen, insbesondere um Fehler auszuschließen oder aufzudecken, die auf menschliche Unachtsamkeit zurückzuführen sind. So soll bevorzugt auch sichergestellt werden, dass bei einem Test auftretende Fehler auf eine Fehlfunktion im Steuergerät zurückzuführen sind, nicht jedoch auf einen Fehler im Testsystem selbst.

Das im Stand der Technik verankerte Problem der fehlerhaften technischen Konfiguration von Hardwarekomponenten, insbesondere das Einbinden technisch nicht geeigneter Hardwarekomponenten in ein Testsystem für die Durchführung einer spezifischen Simulation kann erfindungsgemäß dadurch gelöst werden, dass aus zumindest einem Teil der Hardwarekomponenten wenigstens eine die Hardwarekomponente eindeutig digital identifizierende Komponenteninformation ausgelesen wird und alle ausgelesenen identifizierenden Komponenteninformationen gespeichert werden.

Der wesentliche Kerngedanke des Verfahrens beruht demnach darauf, dass erfindungsgemäß zumindest ein Teil der an ein Testsystem angeschlossenen Hardwarekomponenten eindeutig digital zu identifizieren ist, es sich bei einer solchen identifizierenden Komponenteninformation um eine solche handelt, die direkt aus der Hardwarekomponente ausgelesen werden kann, so dass ein solcher Ausleseprozess automatisiert werden kann und für die Durchführung der Inventarisierung somit auch automatisiert die von den einzelnen Hardwarekomponenten ausgelesenen identifizierenden Komponenteninformationen gesammelt und gespeichert werden können.

Dabei kann es bevorzugt vorgesehen sein, dass zumindest alle solche Hardware-Komponenten mit einer eindeutig digital die Hardwarekomponente identifizierenden Komponenteninformation versehen sind oder versehen werden, die als simulationsindividuell anzusehen sind, das heißt deren nicht korrekter Verbau beziehungsweise Falschkonfiguration in einem Testsystem sich auf das Simulationsergebnis beziehungsweise die Korrektheit des Testergebnisses unmittelbar auswirkt.

So kann es demnach in einem Testsystem zur Durchführung von Tests bei Steuergeräten durchaus Hardwarekomponenten geben, die allgemein für jegliche Art von Simulation und Tests an Steuergeräten eingesetzt werden können, die demnach also nicht simulationsindividuell sind, so dass solche Hardwarekomponenten generell innerhalb eines Testsystems unabhängig von der durchzuführenden Simulation korrekt funktionsfähig sind.

Bei solchen Hardwarekomponenten kann demnach keine Falschkonfiguration beziehungsweise kein fehlerhaftes Einbinden in ein Testsystem stattfinden, so dass es gegebenenfalls vorgesehen sein kann, solche Hardwarekomponenten in der Inventarisierung nicht zu erfassen.

Zumindest erfasst werden jedoch Hardwarekomponenten, die für eine jeweils durchzuführende Simulation speziell einzusetzen sind. Ein Beispiel bildet die bereits eingangs genannte Drosselklappe, die eine als Echtlast zu bezeichnende Hardwarekomponente darstellt, und die als 4-Zylinder-Drosselklappe eine falsche Hardwarekomponente darstellen würde für den individuellen Test einer 6-Zylinder-Drosselklappensteuerung, die z.b. in einem zu testenden Steuergerät implementiert sein kann. In diesem Beispiel kommt es somit darauf an, im Testsystem eine korrekte Paarung aus Steuergerät und Echtlast zu erzielen.

Demnach ist es wichtig, zumindest solche simulationsindividuellen Hardwarekomponenten mit einer eindeutigen digitalen identifizierenden Komponenteninformation zu versehen, sofern diese nicht ohnehin eine identifizierende Komponenteninformation tragen, die zum Zweck der erfindungsgemäßen Inventarisierung verwendet werden kann.

Das Ziel einer Inventarisierung wird erfindungsgemäß bereits dann erreicht, wenn von den zumindest simulationsindividuellen Hardwarekomponenten die jeweiligen identifizierenden Komponenteninformationen alle ausgelesen und gespeichert sind. Das Speichern kann beispielsweise dadurch erfolgen, dass die einzelnen identifizierenden Komponenteninformationen in einem Speicherbereich des Testsystems, insbesondere in einem Rechner des Testsystems oder einem an das Testsystem angeschlossenen Steuerrechner, abgelegt werden.

Das Ablegen der einzelnen identifizierenden Komponenteninformationen kann beispielsweise in der Art einer Liste erfolgen, so dass es auch vorgesehen sein kann, aus den einzelnen identifizierenden Komponenteninformationen eine Datei zu erstellen, die extern gespeichert werden kann, insbesondere zum Zwecke der Dokumentation und der Validierung der Prozesssicherheit. Erfindungsgemäß ist somit durch das Verfahren zumindest das simulationsindividuelle Inventar erfasst und protokollierbar.

Hierbei kann es erfindungsgemäß auch vorgesehen sein, dass das jeweilige Auslesen der identifizierenden Komponenteninformation aus den einzelnen Hardwarekomponenten, insbesondere den simulationsindividuellen Hardwarekomponenten mittels desjenigen Rechners des Testsystems erfolgt, welcher auch die eigentliche Simulation anhand eines Modells, dass heißt eines im Wesentlichen auf dem Rechner vorhandenen durchzuführenden Simulationsalgorithmus durchführt.

Alternativ besteht auch die Möglichkeit, die einzelnen identifizierenden Komponenteninformationen von den jeweiligen Hardwarekomponenten mittels eines an das Testsystem angeschlossenen Steuerrechners vorzunehmen, beispielsweise eines solchen Steuerrechners, mittels welchem eine softwareseitige Konfiguration des Testsystems erfolgt.

Beispielsweise kann mittels eines solchen Steuerrechners auf den Rechner des Testsystems das Modell das heißt die eine bestimmte Umweltbedingung simulierende Software übertragen werden und/oder mit zur Simulation benötigten Parametern versehen werden. Ebenso besteht die Möglichkeit mittels eines solchen Steuer-PCs Ergebnisse aus dem Testsystem auszulesen und gegebenenfalls zu visualisieren, insbesondere zur Überprüfung der Testsysteme durch Benutzer. Auch kann das Inventar, d.h. eine die gespeicherten identifizierenden Komponenteninformationen wiedergebende Liste mittels dieses Steuerrechners visualisiert werden.

Eine erfindungsgemäße Weiterbildung des Verfahrens kann es vorsehen, dass die ausgelesenen und gespeicherten identifizierenden Komponenteninformationen eine technische Ist-Konfiguration des Testsystems beschreiben.

Eine solche Ist-Konfiguration kann beispielsweise in der Form einer Tabelle realisiert sein, die innerhalb eines Speicherbereiches des Rechners des Testsystems oder des daran angeschlossenen Steuerrechners vorliegt oder in der Art einer z.B. auf einem Datenträger oder Massenspeicher gespeicherten Datei, die zur Verwendung einem der genannten Rechner zur Verfügung steht. Eine solche technische Ist-Konfiguration kann demnach zusammengetragen sein aus den einzelnen die Hardwarekomponenten identifizierenden Komponenteninformationen, die in diesem vorgenannten Speicherbereich oder die genannte Datei eingeschrieben werden, z.B. in einer fortlaufend nummerierten Ordnung.

Ein solches Einschreiben in eine Tabelle / Liste und somit Erstellen einer technischen Ist-Konfiguration kann in einer möglichen Ausführung der Erfindung beispielsweise wenigstens einmalig, insbesondere wenigstens einmalig vor Durchführung eines Tests vorgenommen werden.

Unabhängig vom Erstellungszeitpunkt kann vorteilhafterweise vorgesehen sein, die erstellte Ist-Konfiguration zu vergleichen mit einer Soll-Konfiguration des Testsystems, beispielsweise einer solchen, die bei Entwurf des Testsystems erstellt wird. Beispielsweise können hier Nutzer des Testsystems ebenso in der Form einer in einem Speicherbereich oder einer Datel abzulegenden Tabelle die identifizierenden Komponenteninformationen von den für eine Simulation benötigten Hardwarekomponenten zu einer Soll-Konfiguration zusammenfassen, so dass sich erfindungsgemäß die Möglichkeit erschließt, automatisiert, beispielsweise durch den Rechner des Testsystems oder den daran angeschlossenen Steuerrechner einen Vergleich durchzuführen zwischen der benötigten Soll-Konfiguration und der tatsächlichen, automatisch erfassten Ist-Konfiguration des Testsystems, was dadurch erfolgen kann, dass beispielsweise die einzelnen Einträge der in den Speicherbereichen oder in jeweiligen Dateien auf einem Datenträger abgelegten identifizierenden Komponenteninformationen miteinander verglichen werden.

Ein solcher Vergleich kann beispielsweise dadurch vorgenommen werden, dass aus der erfindungsgemäß automatisiert erstellten Ist-Konfiguration wiederholt ein Konfigurationseintrag ausgelesen wird, der, wie eingangs beschrieben, durch eine digital identifizierende Komponenteninformation einer bestimmten Hardwarekomponente gebildet wird und durch Vergleich überprüft wird, ob dieselbe identifizierende Komponenteninformation auch in der gespeicherten Soll-Konfiguration vorhanden ist.

Wird ein solcher Vergleich positiv abgeschlossen, so stellt das erfindungsgemäße Verfahren hierdurch fest, dass eine für die gewünschte Simulation zulässige Hardwarekomponente im Testsystem verbaut ist. Wird der Vergleich hingegen negativ abgeschlossen, also die in der Ist-Konfiguration vorhandene digital identifizierende Komponenteninformation in der Soll-Konfiguration nicht aufgefunden, so liefert dieser negative Vergleich das Ergebnis, das eine für die durchzuführende Simulation unzulässige Hardwarekomponente in dem Testsystem verbaut ist.

Dementsprechend kann bei einem solchen negativen Vergleich eine entsprechende Meldung erfolgen, beispielsweise durch den Rechner des Testsystems oder den daran angeschlossenen Steuerrechner, so dass bedienende Benutzer auf diesen Fehler automatisch aufmerksam gemacht werden und dieser Fehler durch Austausch der Hardwarekomponente behoben werden kann. Hierfür kann die identifizierende Komponenteninformation der betreffenden Hardwarekomponente oder ein dieser zugeordneter Klartext visualisiert werden.

Aufgrund der Tatsache, dass in üblichen Netzwerken darin installierte Hardwarekomponenten eine Identifikation aufweisen, welche diese Hardwarekomponente im genutzten Netzwerk zugeordnet ist, die also beispielsweise eine Netzwerkadresse oder eine Busadresse darstellt, kann eine weitere Ausführung des Verfahrens auch vorsehen, dass sowohl in der Ist- als auch in der Soll-Konfiguration und insbesondere in einer jeweiligen die entsprechende Konfigurationseinträge umfassenden Tabelle neben der eingangs genannten digitalen identifizierenden Komponenteninformation einer Hardwarekomponente auch eben eine solche der Komponente für die Benutzung im Netzwerk zugeordnete Identifikation berücksichtigt wird, das heißt darin gespeichert wird.

So kann durch den Vergleich von Soll- und Ist-Konfiguration anhand der identifizierenden Komponenteninformation und der Identifikation im Netzwerk nicht nur überprüft werden, ob eine installierte Hardwarekomponente korrekt installiert ist hinsichtlich ihrer technischen Eigenschaft, also eine technisch zulässige Komponente ist, sondern es kann konkret auch der Installationsort überprüft werden.

Beispielsweise kann es vorgesehen sein, zu einer solchen Überprüfung eine jeweilige Hardwarekomponente über das Netzwerk anzusprechen, das heißt zu einer Kommunikation aufzufordern, zum Beispiel über den Rechner des Testsystems oder den eingangs genannten Steuerrechner, wobei diese Hardwarekomponente über das Netzwerk auch Ihre im Netzwerk vergebene Identifikation mitsendet, so dass im Rahmen einer solchen Kommunikation diese Netzwerkidentifikation der Hardwarekomponente erfasst werden kann. Sofern eine digital identifizierende Komponenteninformation aus einer Hardwarekomponente über dasselbe Netzwerk aus der Hardwarekomponente ausgelesen werden kann, in welches die Hardwarekomponente zum Zwecke der Simulation beziehungsweise der Durchführung des Tests eingebunden ist, kann es vorgesehen sein, die digital identifizierende Komponenteninformation und die Identifikation die die Hardwarekomponente im Netzwerk aufweist, in demselben Kommunikationsschritt von einer betreffenden Hardwarekomponente zu lesen.

Sind hingegen die digital identifizierenden Komponenteninformationen nicht über dasselbe Netzwerk aus einer Hardwarekomponente auszulesen, welches von der Hardwarekomponente innerhalb des Testsystems zur Durchführung der Simulation genutzt wird, so kann es erfindungsgemäß vorgesehen sein, die Identifikation einer jeweiligen Hardwarekomponente im Netzwerk sowie die digitale identifizierende Komponenteninformation durch separate Kommunikationsvorgänge zu erfassen und einander zuzuordnen, das heißt aus der jeweiligen Hardwarekomponente auszulesen und sodann diese beiden Informationen als eine Ist-Konfiguration zu speichern, beispielsweise durch Zusammenfassung dieser beiden Informationen in einer Tabelle, die gemäß bereits vorgenannter Ausführung in einem bestimmten Speicherbereich oder in einer Datei eines Massenspeichers des Rechners des Testsystems oder des daran angeschlossenen Steuerrechners gespeichert ist.

Ein wesentlicher Vorteil des erfindungsgemäßen Verfahrens ist es, dass die Möglichkeit besteht, vor einer erstmaligen Durchführung eines Tests eines Steuergerätes im Rahmen einer Simulation die beschriebene Inventarisierung und gegebenenfalls die Überprüfung zwischen tatsächlicher Ist-Konfiguration und benötigter Soll-Konfiguration vorzunehmen, so dass zumindest zu Beginn eines Tests die fehlerfreie Konfiguration eines Testsystems geprüft und gegebenenfalls auch dokumentiert werden kann, zum Beispiel durch Speicherung der ermittelten Ist-Konfiguration und deren Verifikation durch gegebenenfalls weitere Speicherung der Vergleichsergebnisse, insbesondere wobei diese jeweiligen Informationen in einer extern aufbewahrten Datei für spätere Überprüfungszwecke bewahrt werden.

Vorteilhafterweise erschließt das erfindungsgemäße Verfahren jedoch auch die Möglichkeit, sowohl eine Erstellung der Ist-Konfiguration, insbesondere auch ein Vergleich der Ist-Konfiguration mit einer Soll-Konfiguration nicht nur einmalig, sondern mehrmalig, bevorzugt zyklisch wiederholt durchzuführen.

Durch eine solche insbesondere zyklisch wiederholte Durchführung kann demnach auf einfache Art und Weise erneut geprüft werden, ob sich die Ist-Konfiguration im Lauf der Zeit ändert, was beispielsweise dadurch erfolgen kann, dass Benutzer, die das Testsystem konfigurieren, Änderungen an diesem vornehmen, so dass automatisch auch jede gegebenenfalls vorgenommene Änderung zum einen inventarisierbar und somit dokumentierbar ist, zum anderen aber auch durch den beschriebenen Vergleich zwischen Ist- und Soll-Konfiguration überprüfbar ist.

Besonders bevorzugt kann es hierbei auch vorgesehen sein, eine solche insbesondere zyklische Wiederholung zur Laufzeit eines Tests durchzuführen, um somit sicherzustellen, dass sich während der Laufzeit die Testbedingungen, insbesondere die für die Durchführung eines Tests benötigte Hardware, nicht ändern oder nur in zulässiger Weise ändern.

Eine erste mögliche vorteilhafte weitere Ausführung des erfindungsgemäßen Verfahrens kann es vorsehen, dass aus einer eingangs genannten Hardwarekomponente eine digital identifizierende Komponenteninformation ausgelesen wird aus einem für die Funktion der Hardwarekomponente während eines Tests vorgesehenen Elektronikbauteil, wie beispielsweise einem Chip oder Prozessor.

So kann hier der Umstand ausgenutzt werden, dass Elektronikbauteile, wie die beispielsweise genannten Chips oder Prozessoren, herstellerseitig bereits mit dieses spezielle Elektronikbauteil identifizierenden Informationen ausgestattet sind, wie beispielsweise einer Seriennummer, so dass solche Elektronikbauteile selbst bei einer Serienfertigung von identischen Elektronikbauteilen jeweils eine eigene identifizierende Information beinhalten, die sodann aus einem solchen Elektronikbauteil auch auf elektronischem Wege, zum Beispiel durch Kommunikation über ein Netzwerk oder einen Bus, aus einem solchen Elektronikbauteil ausgelesen werden kann und als eine digital identifizierende Komponenteninformation derjenigen Hardwarekomponente erfindungsgemäß genutzt werden kann, in welcher ein solches Elektronikbauteil eingebaut ist.

Das hier für die Funktion während eines Tests vorgesehene Elektronikbauteil ist dabei weiterhin ein solches Bauteil, welches in der jeweiligen Hardwarekomponente während der Durchführung eines Tests in bevorzugter Ausführung konkret benutzt wird. Dies ist beispielsweise der Fall bei einem Prozessor, auf welchem während der Durchführung eines Tests Prozessschritte durchgeführt werden, oder aber auch bei einem Chip, der einen Speicherbereich darstellt, aus welchem während des Tests Daten gelesen oder in welchem während des Tests Daten geschrieben werden, demnach also während der Durchführung eines Testes konkret für den Test genutzt wird.

Eine andere Ausführung, die auch mit der vorherigen kombinierbar ist, kann vorsehen, dass eine digitale identifizierende Komponenteninformation einer Hardwarekomponente ausgelesen wird aus einem für die Funktion der Hardwarekomponente während eines Tests nicht benötigten Elektronikbauteil, wie beispielsweise einem Chip, wobei ein solches Elektronikbauteil demnach zum Zweck der Bereitstellung einer identifizierenden Komponenteninformation an der Hardwarekomponente angeordnet ist, also in einer möglichen Ausführungsform keine andere Funktion aufweist, als das Tragen beziehungsweise zum Auslesen Beinhalten der identifizierenden Komponenteninformation und ansonsten zumindest für die Durchführung eines Tests im Rahmen einer Simulation keine weitere Funktion hat, also am Test selbst nicht teilnimmt.

Bei dieser Ausführung erschließt es sich als vorteilhaft, dass Hardwarekomponenten, die ursprünglich nicht eindeutig digital identifiziert werden können, beispielsweise weil sie keine Elektronikbauteile aufweisen, die bereits eine eigene Identifikation haben, für den Zweck des erfindungsgemäßen Verfahrens extra ausgerüstet werden, zum Beispiel durch Anbringung eines zusätzlichen Elektronikbauteils an der Hardwarekomponente, um sodann die digitale identifizierende Komponenteninformation dieses Elektronikbauteils insbesondere stellvertretend für die Hardwarekomponente aus diesem Elektronikbauteil auszulesen und im Rahmen der Inventarisierung und gegebenenfalls der vorgenannten Vergleiche zu verwenden.

Es ergibt sich demnach auch eine kostengünstige Nachrüstmöglichkeit für bereits zu Testzwecken bestehende Hardwarekomponenten, die bislang nicht digital identifizierbar waren und durch das Anbringen eines entsprechenden Elektronikbauteils digital identifizierbar werden.

Eine weitere Ausführung des erfindungsgemäßen Verfahrens kann es hier auch vorsehen, dass eine Hardwarekomponente ohne ein eigenes, wenigstens eine identifizierende Komponenteninformation tragendes Elektronikbauteil verbunden wird mit einer Hardwarekomponente, die ein eigenes eine identifizierende Komponenteninformation tragendes Bauteil aufweist und hierdurch beide Hardwarekomponenten zu einer neuen Einheit verbunden werden, insbesondere zu einer solchen Einheit, die nicht ohne Zerstörung trennbar ist.

Dies kann beispielsweise durch Verschrauben, Versiegeln oder Verplomben der Verbindung zwischen den beiden Hardwarekomponenten erfolgen. Durch das Vorhandensein einer digital identifizierenden Komponenteninformation an somit zumindest einer Hardwarekomponente der neu gebildeten Einheit, kann demnach die gesamte neue Einheit digital identifiziert werden. Selbstverständlich besteht hier auch die Möglichkeit mehr als zwei Hardwarekomponenten zu einer Einheit zusammenzufassen, wobei sodann wenigstens eine dieser mehreren Hardwarekomponenten ein eigenes Elektronikbauteil mit einer identifizierenden Komponenteninformation umfasst, von welcher sodann die gesamte aus mehreren Teilen zusammengefügte Einheit profitiert, das heißt hierdurch identifiziert werden kann.

Bei der Durchführung des erfindungsgemäßen Verfahrens kann es weiterhin vorgesehen sein, dass ein Teil von Hardwarekomponenten des Testsystems mittels eines ersten Netzwerkes, beispielsweise mit einem ersten Bus an den Rechner des Testsystems angeschlossen ist und ein (anderer) Teil von Hardwarekomponenten des Testsystems, wie beispielsweise ein zu testendes Steuergerät und/oder Echtlasten mittels eines zweiten Netzwerkes, beispielsweise mit einem zweiten Bus an den Rechner des Testsystems angeschlossen ist, wobei die beiden Netzwerke, insbesondere die verwendeten Busse mittels eines Gateways verbunden sind, so dass sich hierdurch die Möglichkeit erschließt, Signale oder Daten auf einem der beiden Netzwerke auf das jeweils andere Netzwerk beziehungsweise den anderen Bus zu übertragen, insbesondere wobei ein solches Gateway beispielsweise eine Protokolltransformation vornehmen kann, sofern die beiden Netzwerke beziehungsweise Busse mit einem unterschiedlichen Kommunikationsprotokoll arbeiten.

Beispielsweise kann es hier vorgesehen sein, dass als erstes Netzwerk ein solches Netzwerk benutzt wird, welches proprietär von einem Hersteller zumindest des Rechners des Testsystems gegebenenfalls auch für das Testsystem vorgesehener, zwingender, insbesondere nicht simulationsindividueller Komponenten verwendet wird, wohingegen als zweites Netzwerk ein gegebenenfalls standardisiertes Netzwerk verwendet werden kann, um über ein solches Netzwerk oder einen standardisierten Bus weitere, insbesondere externe Komponenten, wie die eingangs genannten Steuergeräte oder externe (Echt-) Lasten, an den Rechner des Testsystemes anzuschließen.

Ein Beispiel für ein erstes Netzwerk kann das Netzwerk beziehungsweise der Bus IOCNET der Anmelderin dieser Erfindung eingesetzt werden, wobei als zweites Netzwerk der zum Beispiel in der Automobilindustrie etablierte CAN-Bus Verwendung finden kann. Es ist darauf hinzuweisen, dass die hier beschriebene Erfindung nicht auf die hier konkret benannten Netzwerke beziehungsweise Busse beschränkt ist, sondern selbstverständlich auch andere Netzwerke beziehungsweise Busse Verwendung finden können.

Durch die beschriebene Verwendung eines Gateways zur Verbindung der wenigstens zwei Netzwerke kann so sichergestellt werden, dass identifizierende Komponenteninformationen von an das zweite Netzwerk angeschlossenen Hardwarekomponenten unmittelbar über das zweite Netzwerk ausgelesen werden von einer jeweiligen Hardwarekomponente und beispielsweise über das Gateway, insbesondere ein erstes Gateway auf das erste Netzwerk übertragen werden, insbesondere in welchem der Rechner des Testsystems angeordnet ist, so dass die identifizierenden Komponenteninformationen zumindest diesem Rechner zum Zwecke der Inventarisierung und/oder der Durchführung der eingangs genannten Vergleiche zur Verfügung steht, beziehungsweise über dieses Netzwerk auch an einen an das Testsystem angeschlossenen Steuerrechner übermittelt werden kann zu dem selben Zweck. Dies setzt voraus, dass ein Elektronikbauteil, sei es originär vorhanden oder nachgerüstet, an wenigstens eines der wenigstens zwei genannten Netzwerke (Busse) angeschlossen ist.

Ist hingegen eine identifizierende Komponenteninformation aus einer Hardwarekomponente, die im Testsystem eingebunden ist, weder über das eingangs genannte erste Netzwerk noch über das eingangs genannte zweite Netzwerk von der Hardwarekomponente auslesbar, was beispielsweise der Fall sein kann, wenn es sich um solche Hardwarekomponenten handelt, an denen zum Zweck der Bereitstellung einer identifizierenden Komponenteninformation ein Elektronikbauteil ohne Bedeutung für die Funktion der Hardwarekomponente während eines Tests angeordnet ist, so kann es hier auch vorgesehen sein, die jeweilige identifizierende Komponenteninformation mittels einer jeweiligen eigenständigen Datenverbindung, also einer für die jeweils betrachtete Hardwarekomponente individuellen Datenverbindung auszulesen, und die auszulesenden Daten sodann mittels wenigstens eines zweiten Gateways auf das zweite Netzwerk oder alternativ unmittelbar auf das erste Netzwerk aufzuschalten.

Gegebenenfalls kann es hier auch vorgesehen sein, mittels der beschriebenen jeweiligen Datenverbindung ein direktes Aufschalten unter Umgehung jeglicher Netzwerkkommunikation auf einen Rechner, insbesondere den des Testsystems, oder den Steuerrechner vorzunehmen, welcher die erfindungsgemäße Inventarisierung, das heißt das Sammeln und Speichern zumindest der digital identifizierenden Komponenteninformationen, gegebenenfalls auch die vorbeschriebenen Vergleiche vornimmt.

Die vorgenannte Datenverbindung kann in einer bevorzugten, kostengünstig und technisch einfach zu realisierenden Ausgestaltung zum Beispiel durch einen Ein-Draht-Bus zwischen jeweiligem Elektronikbauteil und einem Gateway, insbesondere einem zweiten Gateway ausgebildet sein, sofern die Datenverbindung zu dem zweiten oder ersten Netzwerk erfolgt. Eine Datenverbindung ohne Gateway kann bei der direkten Aufschaltung auf einen der vorgenannten Rechner vorgenommen werden.

Bei einer Aufschaltung der Daten, das heißt der digitalen identifizierenden Komponenteninformationen mittels eines Gateways auf eines der beiden Netzwerke, bevorzugt auf das zweite genannte Netzwerk, wie zum Beispiel den CAN-Bus, kann es hier vorgesehen sein, dass mit wenigstens einem Gateway, insbesondere wenigstens einem zweiten Gateway die Daten von mehreren Ein-Draht-Bussen der Elektronikbauteile verschiedener Hardwarekomponenten, die physikalisch parallel an Ports des wenigstens einen, insbesondere zweiten Gateways anliegen, umgesetzt werden in Daten, die an verschiedene Adressen des zweiten oder ersten Netzwerkes auslesbar sind, wobei jede der verschiedenen Adressen genau einem Port des wenigstens einen, insbesondere zweiten Gateways zugeordnet ist und bevorzugt, wobei die Adressen in einer numerischen Reihenfolge der Ports geordnet sind.

Eine solche Ausführung erschließt eine technisch einfache Möglichkeit, die digital identifizierenden Komponenteninformationen in einem der Netzwerke, bevorzugt dem zweiten Netzwerk, wie beispielsweise einem CAN-Bus, verfügbar zu machen beziehungsweise über dieses Netzwerk, insbesondere ein CAN-Bus, von den jeweiligen Elektronikbauteilen der verschiedenen Hardwarekomponenten auszulesen, da in einer solchen Ausgestaltung verfahrensgemäß im Wesentlichen der Dateninhalt an einer einem jeweiligen Port zugeordneten Adresse des Netzwerkes gelesen wird und so von dieser Adresse demnach direkt die digitale identifizierende Komponenteninformation gelesen werden kann, die über den vorgenannten jeweiligen Port an diese Adresse weitergeleitet ist.

Besonders bei einer numerisch gegebenen Reihenfolge der Ports und einer ebenso numerischen gereihten Zuordnung von Adressen zu diesen Ports, kann durch ein einfaches Abfragen eines Intervalls von aufeinanderfolgenden Adressen, die Mehrzahl der an dem Gateway zur Verfügung stehenden Ports und damit die an diesen Ports anliegenden identifizierenden Komponenteninformationen der jeweiligen Hardwarekomponenten gelesen werden.

Die identifizierenden Komponenteninformationen aller über einen solchen Ein-Draht-Bus an das Testsystem angeschlossenen Hardwarekomponenten stehen somit in dem Netzwerk zur Verfügung, welches mit dem genannten, insbesondere zweiten Gateway verbunden ist, somit insbesondere im zweiten Netzwerk und in bevorzugter Ausgestaltung in einem CAN-Bus.

Statt dem bereits zuvor genannten direkten Einlesen der identifizierenden Komponenteninformationen über die Datenverbindung und bevorzugt den Ein-Draht-Bus zwischen Elektronikbauteil und Rechner unter Umgehung derjenigen gegebenenfalls mehreren vorhandenen Netzwerke, in welchem die einzelnen Hardwarekomponenten während der Durchführung eines Tests miteinander kommunizieren, kann es auch vorgesehen sein, für die Übertragung und für das Auslesen der identifizierenden Komponenteninformation, ein drittes Netzwerk bereitzustellen, welches für die Simulation einer Testumgebung innerhalb des Testsystems nicht genutzt ist und somit im Wesentlichen ausschließlich für die Kommunikation der identifizierenden Komponenteninformationen genutzt wird.

So kann auch mittels eines solchen dritten Netzwerkes eine Übertragung der identifizierenden Komponenteninformation an den Rechner des Testsystems oder an einem an das Testsystem angeschlossenen Steuerrechner übertragen werden, um mit alternativ einem dieser beiden Rechner die Inventarisierung beziehungsweise gegebenenfalls die Vergleiche durchzuführen. Hierzu ist der verwendete Rechner ebenso an dieses dritte Netzwerk anzuschließen.

Vorteilhaft ist die Ausführung mittels eines solchen dritten Netzwerkes oder aber auch mittels der eingangs genannten Direktverbindung der Elektronikbauteile mit einem der beiden Rechner, da das Durchführen der erfindungsgemäßen Inventarisierung sowie der eventuellen Vergleiche selbst dann eine Simulation, das heißt einen Test eines Steuergerätes nicht stört, sofern die Inventarisierung insbesondere zyklisch während der Laufzeit eines Tests vorgenommen wird.

Echtzeitanforderungen an das Testsystem können somit problemlos während der Durchführung eines Tests fortwährend aufrechterhalten werden, ohne eine Beeinflussung durch die erfindungsgemäße Inventarisierung beziehungsweise die Vergleiche befürchten zu müssen.

Eine andere Ausführung kann es jedoch auch vorsehen, dass eine Inventarisierung und gegebenenfalls ein Vergleich, insbesondere auch mehrfach während der Laufzeit eines Tests, durchgeführt wird, dies jedoch nicht zyklisch, dass heißt nicht mit wiederkehrend gleichem zeitlichen Abstand vorgenommen wird, sondern das Durchführen der Inventarisierung beziehungsweise das Vergleichen in Kommunikationspausen auf dem während eines Tests beteiligten wenigstens einen Netzwerk vorgenommen wird.

Sofern solche Kommunikationspausen nicht lang genug sind, um eine vollständige Inventarisierung innerhalb einer solchen Pause vorzunehmen, kann es vorgesehen sein, die Inventarisierung innerhalb von solchen Kommunikationspausen jeweils teilweise durchzuführen, also beispielsweise wenigstens einen Ausleseschritt bezüglich einer identifizierenden Komponenteninformation einer bestimmten Komponente durchzuführen und so über mehrere aufeinander folgende Kommunikationspausen hinweg die Gesamtinventarisierung vorzunehmen, bis dass von allen an das Testsystem angeschlossenen, zumindest simulationsindividuellen Hardwarekomponenten die jeweiligen Komponenteninformationen ausgelesen und gespeichert sind, wobei sodann auch innerhalb von Kommunikationspausen gegebenenfalls die vorgenannten Vergleiche zwischen Ist- und Soll-Konfiguration vorgenommen werden können, ggfs. ebenso abschnittsweise.

Unter den Kommunikationspausen werden bevorzugt diejenigen Zeiten verstanden, zu denen auf dem wenigstens einen verwendeten Netzwerk, insbesondere den verwendeten Bus-Systemen keine Datenpakete kommuniziert werden, die zur Simulation gehören.

Insbesondere dann, wenn in einem Netzwerk ein Zeitmanagement vorgesehen ist, was zum Beispiel durch eine an das Netzwerk angeschlossene Hardwarekomponente, beispielsweise den Rechner des Testsystems vorgenommen wird, kann es bestimmt werden, wann während der Durchführung eines Tests gegebenenfalls für den Test selbst nicht genutzte Zeitschlitze auf dem Netzwerk zur Verfügung stehen, um in diesen Zeitschlitzen sodann die Kommunikation der digitalen identifizierenden Komponenteninformationen durchzuführen, insbesondere ohne die Echtzeitfähigkeit des durchgeführten Tests zu beeinflussen.

Ausführungsbeispiele der Erfindung werden im Nachfolgenden beschrieben.

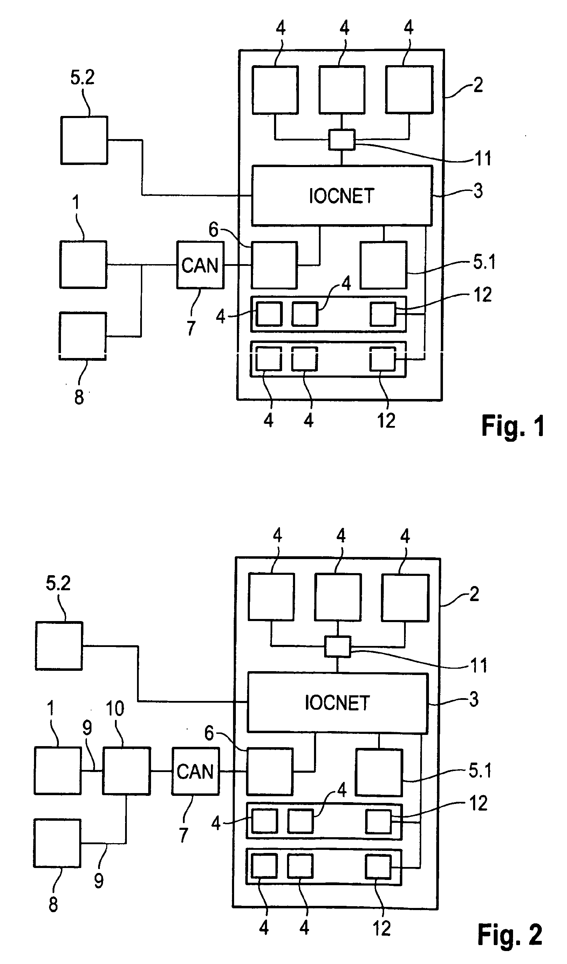

Die Figur 1 zeigt in einer insgesamten Darstellung in der Form eines Blockdiagramms ein Testsystem zur Durchführung eines Tests eines Steuergerätes, bei welchem einem Steuergerät 1 mittels einer Simulationsarchitektur 2 eine Umgebung simuliert wird, insbesondere eine solche Umgebung, die auch bei dem konkreten Einsatz des Steuergerätes 1 in einer späteren Vorrichtung, wie beispielsweise einem Kraftfahrzeug vorliegt.

Die Simulationsarchitektur 2 kann bereits mehrere Hardwarekomponenten, z.B. einen Rechner 5.1 des Testsystems umfassen und zum Beispiel durch ein proprietäres System eines bestimmten Herstellers realisiert sein. Vorliegend wird ein System der Patentanmelderin dargestellt, bei welchem über ein erstes Netzwerk 3 mehrere Hardwarekomponenten 4 miteinander kommunizieren und durch diese Hardwarekomponenten sowie einen Rechner 5.1, der auch das erfindungsgemäße Inventarisierungsverfahren durchführt, anhand eines Modells eine Testumgebung simuliert wird. Hier können die Hardwarekomponenten 4 z.B. durch intelligente Knoten 11 oder Router 12 in das Netzwerk 3 eingebunden sein, insbesondere sofern sie nicht selbst geeignete Netzwerkschnittstellen aufweisen.

Hier kann es vorgesehen sein, dass über das gleiche erste Netzwerk 3 auch ein an das Testsystem angeschlossener Steuerrechner 5.2 vorgesehen ist, beispielsweise um das Testsystem zu parametrisieren beziehungsweise die benötigte Software oder ein Modell aufzuladen und zu starten oder aus sonstigen Gründen mit dem Testsystem zu kommunizieren.

Die hier beschriebene konkrete Ausführungsform zeigt, dass das Testsystem beziehungsweise hier konkret der Teil der proprietären Simulationsarchitektur ein Gateway 6, insbesondere im Folgenden ein als erstes Gateway bezeichnetes Gateway 6 aufweist, mit welchem die Möglichkeit besteht, über ein standardisiertes zweites Netzwerk 7, im vorliegenden Fall einen CAN-Bus, zur Ausbildung des gesamten Testsystems an die proprietäre Hardwarearchitektur weitere externe Komponenten anzuschließen, nämlich hier das zu testende Steuergerät 1 und gegebenenfalls weitere Echtlasten 8, wie sie eingangs im allgemeinen Teil der Beschreibung benannt sind.

Ein solches (erstes) Gateway (6) muss nicht zwingend als separate Hardwarekomponente im Testsystem realisiert sein, sondern kann auch einen Teil einer anderen Hardwarekomponente ausbilden, z.B. einen Teil des Rechners (5.1) oder des Rechners (5.2). Sämtliche Komponenten können demnach über die beiden Netzwerke 3 und 7 miteinander kommunizieren und so ein Test durchgeführt werden.

Für das erfindungsgemäße Verfahren ist es hier vorgesehen, dass mittels des Rechners 5.1 des Testsystems, der in diesem Beispiel das sogenannte Inventarmanagement durchführt, das heißt die Durchführung des erfindungsgemäßen Verfahrens vornimmt, von den einzelnen Hardwarekomponenten und zwar zumindest den simulationsindividuellen Hardwarekomponenten, wie beispielsweise dem Steuergerät 1 und den Lasten 8 sowie gegebenenfalls in der Simulationsarchitektur 2 vorgesehenen simulationsindividuellen Hardwarekomponenten 4, digitale identifizierende Komponenteninformationen einliest, die zum Beispiel als Seriennummer, beispielsweise als 64 Bit-Seriennummer von Elektronikbauteilen auf/an den jeweiligen Komponenten gebildet werden können.

Selbstverständlich besteht hier auch die Möglichkeit, solche identifizierende Komponenteninformationen von solchen Komponenten verfahrensgemäß einzulesen, die nicht simulationsindividuell sind, jedoch dennoch im Rahmen der Inventarisierung zum Zwecke der Erfüllung der Prozesssicherheit einer eventuellen Dokumentation erfasst werden sollen.

Da in dieser Ausführung der Figur 1 die externen Hardwarekomponenten 1 und 8 über das zweite Netzwerk 7, wie beispielsweise einen CAN-Bus und über ein Gateway 6 mit dem ersten Netzwerk 3 des Testsystems verbunden sind, ist es demnach vorgesehen, hier auch die digitalen identifizierenden Komponenteninformationen über das erste Gateway 6 von dem zweiten Netzwerk in das erste Netzwerk und somit zum Rechner 5.1 des Inventarmanagements zu übertragen. Identifizierende Komponenteninformationen von Komponenten am Netzwerk 3 werden direkt über dieses Netzwerk von den Komponenten ausgelesen, sofern ein solches Auslesen als nötig angesehen wird, insbesondere also bei ebenso simulationsindividuellen Komponenten am Netzwerk 3.

Wie eingangs beschrieben, kann der Rechner 5.1 die eingelesenen identifizierenden Komponenteninformationen zusammensammeln und speichern, zum Beispiel zum Zweck der Dokumentation, oder auch vergleichen mit einer Soll-Konfiguration, die durch einen Benutzer vorgegeben ist und zum Beispiel durch den an das Testsystem angeschlossenen Steuer-PC 5.2 zur Verfügung gestellt wird.

Alternativ kann statt des Vergleiches im Rechner 5.1 des Testsystems dieser Vergleich auch im an das Testsystem angeschlossenen Steuerrechner 5.2 stattfinden, wofür sodann die zusammengestellte Inventarinformation, das heißt die Information über sämtliche, von den einzelnen Hardwarekomponenten ausgelesenen digitalen Komponenteninformationen an den Steuerrechner übertragen werden, hier wiederum über das erste Netzwerk 3.

Die zweite Ausführungsform gemäß der Figur 2 visualisiert eine leicht geänderte Anwendung, bei der im vorliegenden Fall die digitalen identifizierenden Komponenteninformationen nicht direkt über das erste oder auch das zweite Netzwerk von allen Hardwarekomponenten eingelesen werden, sondern bei dem zumindest ein Teil der Hardwarekomponenten, in diesem Beispiel das Steuergerät 1 und Echtlasten 8, die identifizierenden Komponenteninformationen über eine jeweilige separate Datenverbindung 9, beispielsweise einen Ein-Draht-Bus zur Verfügung stellen, so dass hier in dieser Ausführung ein zweites Gateway 10 verwendet werden kann, um die auf dem Ein-Draht-Bus beziehungsweise der separaten Datenverbindung 9 liegenden digitalen identifizierenden Komponenteninformationen in diesem Beispiel auf das zweite Netzwerk 7, beispielsweise den CAN-Bus, zu übertragen beziehungsweise darauf verfügbar zu machen. Diese Ausführung ist insbesondere dann vorgesehen, wenn die identifizierenden Komponenteninformationen in separaten Elektronikbauteilen der Hardwarekomponenten vorgehalten werden, die selbst nicht am Test teilnehmen und somit auch nicht auf einem der Netzwerke kommunizieren, die für den Test genutzt werden.

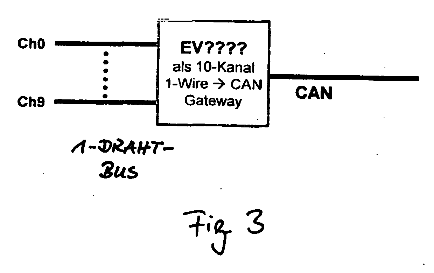

Die Figur 3 zeigt eine beispielhafte Ausführung des Gateways 10, welches beispielsweise unter Nutzung des Controllers EV1097 realisiert werden kann, an dessen Eingangsports 0 bis 9, hier bezeichnet als CH0 bis CH9, jeweils ein Ein-Draht-Bus eines Elektronikbauteils einer Hardwarekomponente angeschlossen ist, insbesondere eines solchen Elektronikbauteils, welches vorgesehen ist, um an der Hardwarekomponente eine digitale Komponenteninformation bereitzustellen und wofür beispielsweise ein Ein-Draht-EEPROM z.B. vom Typ DS2431 verwendet werden kann.

Ein solcher EEPROM kann eine 64-Bit-Seriennummer bereitstellen, die über den Ein-Draht-Bus übertragen werden kann und verwendet werden kann zur Identifikation der Hardwarekomponente, die dieses Elektronikbauteil, das heißt diese EEPROM trägt.

Die Figur 3 visualisiert nun, dass mittels des zweiten Gateway 10 eine physikalische Umsetzung der Daten, das heißt der digitalen identifizierenden Komponenteninformation an den Ports CH0 bis CH9 auf das zweite Netzwerk 7 und hier bevorzugt einen CAN-Bus erfolgt, so dass dieses zweite Netzwerk im Wesentlichen einen N-zu-1-Multiplexer bildet, bei dem N-Ports, im vorliegenden Fall zehn verschiedene Ports oder Kanäle auf einen Bus übertragen werden, an welchem die Inhalte der Ports, das heißt die daran anliegenden digitalen Komponenteninformationen, in aufeinanderfolgenden Adressen eines Adressintervalls, welches in der Intervallbreite der Anzahl der Ports entspricht, aufgeschaltet wird.

So kann durch das Auslesen von aufeinanderfolgenden Adressen dieses jeweiligen Intervalls im Netzwerk 7 beispielsweise einem CAN-Bus, die Gesamtheit aller an dieses zweite Netzwerk 7 angeschlossenen Hardwarekomponenten hinsichtlich ihrer jeweiligen digitalen identifizierenden Komponenteninformationen erfasst werden.

Bei einer Anzahl von Hardwarekomponenten, die über die Anzahl der Ports eines zweiten Gateway 10 hinausgehen, kann es dementsprechend vorgesehen sein, mehrere zweite Gateways 10 zu verwenden, die ihre jeweiligen Ports auf einander nicht überlappende Adressbereiche des zweiten Netzwerkes, insbesondere des CAN-Bus, weiterleiten, insbesondere auf Adressen in benachbarten Intervallen, die ohne Lücke aneinander anschließen.

Unabhängig von den hier gezeigten konkreten Ausführungsformen der Figuren 1 bis 3 kann es vorgesehen sein, dass der an das Testsystem angeschlossene Steuerrechner 5.2 eine insbesondere durch einen Nutzer gegebenenfalls auch automatisiert erstellte Soll-Konfiguration des Testsystems aufweist, wobei diese Soll-Konfiguration zumindest eine Auflistung der für die Durchführung eines Tests benötigten beziehungsweise zugelassenen identifizierenden Komponenteninformationen von zugelassenen Hardwarekomponenten umfasst.

Da nun das erfindungsgemäße Verfahren vorsieht, von den Hardwarekomponenten die jeweiligen identifizierenden digitalen Komponenteninformationen, wie beispielsweise Seriennummern der darauf angeordneten Elektronikbauteilen, auszulesen und aus den gelesenen Informationen eine Ist-Konfiguration zu bilden, wofür diese Information zum Beispiel in einer Tabelle, beispielsweise in einem Speicherbereich oder einer Datei, zusammengefasst werden, kann ein erfindungsgemäßer Vergleich der Ist-Konfiguration und der Soll-Konfiguration stattfinden und sowohl die Ist-Konfiguration zum Zwecke der Dokumentation gespeichert werden als auch die gegebenenfalls vorhandenen Vergleichsergebnisse zum Zwecke der Dokumentation der einwandfreien Konfiguration.

Sollten im Rahmen des Vergleiches Diskrepanzen zwischen Ist- und Soll-Konfiguration auftreten, so können diese unmittelbar angezeigt werden, zum Beispiel durch Kommunikation des Vergleichsergebnisses an den Rechner 5.2, sofern nicht dieser selbst die Vergleiche durchführt. Auf ein solches Vergleichsergebnis kann dementsprechend korrigierend eingewirkt werden, beispielsweise durch Austausch einer Hardwarekomponente gegen eine für den jeweiligen Test zugelassenen Komponente.

Für die Durchführung der Kommunikation und demnach das Zusammensammeln der einzelnen identifizierenden Komponenteninformationen ist es irrelevant, ob die im Rahmen der jeweiligen Kommunikation versendeten Daten-Pakete, welche die identifizierenden Komponenteninformationen beinhalten, auf Anforderung des Rechners 5.1 im Testsystem oder Anforderung des Rechners 5.2 im Testsystem erfolgt, oder ob die einzelnen Hardwarekomponenten durch Eigeninitiative ihre Komponenteninformationen versenden und die versendeten Komponenteninformationen beziehungsweise die diese enthaltenden Kommunikationspakete im Rahmen des erfindungsgemäßen Verfahrens von einem der beiden Rechner eingesammelt werden.

Wesentlich für die Erfindung verbleibt als Unterschied zum Stand der Technik, dass durch Falschkonfiguration aufgrund menschlicher Unzulänglichkeiten entstandene Fehler innerhalb eines Testsystems bereits vor der Durchführung eines Tests aufgedeckt werden können, bevorzugt während der Durchführung eines Tests überprüfbar sind und sich so die Möglichkeit erschließt, im Rahmen einer Qualitätssicherung die konkreten Ist-Konfigurationen zu protokollieren und für einen späteren Abruf zu speichern.

## Patentansprüche

1. Verfahren zur Durchführung einer Inventarisierung der an ein Steuergeräte-Testsystem angeschlossenen Hardware-Komponenten (1,4,6,8), wobei mit dem Testsystem Steuergeräte (1) in einer vom Testsystem mittels eines Modells simulierten Umgebung testbar sind und wobei das Testsystem zumindest einen Rechner (5.1) und Hardware-Komponenten (1,4,6,8) umfasst, die mittels wenigstens eines Netzwerks (3,7) miteinander verbunden sind, wobei aus zumindest einem Teil der Hardware-Komponenten (1,4,6,8), wenigstens eine die Hardware-Komponente (1,4,6,8) eindenlig digital identifizierende Komponenten-Information ausgelesen wird und alle ausgelesenen identifizierenden Komponenteninformationen gespeichert werden, **dadurch gekennzeichnet, dass** eine Komponenten-Information die Hardwarekomponente jeweils eindeutig identifiziert und ausgelesen wird aus einem für die Funktion der Hardware-Komponente (1,4,6,8) während eines Tests nicht benötigten Elektronikbauteil, welches zum Zweck der Bereitstellung einer identifizierenden Komponenteninformation an der Hardware-Komponente (1,4,6,8) angeordnet wird.

2. Verfahren nach Anspruch 1, **dadurch gekennzeichnet, dass** das Auslesen der identifizierenden Komponenteninformationen mittels des Rechners (5.1) des Testsystems oder mittels eines an das Testsystem angeschlossenen Steuer-Rechners (5.2) erfolgt.

3. Verfahren nach einem der vorherigen Ansprüche, **dadurch gekennzeichnet, dass** die ausgelesenen und gespeicherten identifizierenden Komponenteninformationen eine technische Ist-Konfiguration des Testsystems beschreiben, insbesondere in Form einer Tabelle, die verglichen wird mit einer beim Entwurf des Testsystems erstellten und gespeicherten Soll-Konfiguration, insbesondere durch Vergleich der jeweiligen Konfigurationseinträge, insbesondere wobei der Vergleich durchgeführt wird durch den Rechner (5.1) des Testsystems oder einen an das Testsystem angeschlossenen Steuer-Rechner (5.2).

4. Verfahren nach einem der vorherigen Ansprüche, **dadurch gekennzeichnet, dass** in der Ist- und Sollkonfiguration, insbesondere in einer jeweiligen die Konfigurationseinträge umfassenden Tabelle, eine Identifikation einer Hardware-Komponente (1,4,6,8) berücksichtigt wird, welche dieser im genutzten Netzwerk (3,7) zugeordnet ist, insbesondere welche einer Netzwerk- oder Busadresse des genutzten Netzwerkes (3,7) entspricht und die bei einer Kommunikation der Hardware-Komponente (1,4,6,8) über das Netzwerk (3,7) mitversendet wird und durch Vergleich von Ist- und Sollkonfiguration anhand der identifizierenden Komponenteninformation und der Identifikation überprüft wird, ob installierte Hardware-Komponenten (1,4,6, 8) korrekt installiert sind hinsichtlich technischer Eigenschaft der Hardware-Komponente (1,4,6,8) und Installationsort.

5. Verfahren nach einem der vorherigen Ansprüche 3 oder 4, **dadurch gekennzeichnet, dass** eine Erstellung der Ist-Konfiguration und ein Vergleich mit der Soll-Konfiguration wiederholt wird, insbesondere zur Laufzeit eines Tests, insbesondere zyklisch oder in auf dem genutztem Netzwerk (3,7) vorkommenden Kommunikationspausen.

6. Verfahren nach einem der vorherigen Ansprüche, **dadurch gekennzeichnet, dass** eine Hardware-Komponente ohne ein eigenes, wenigstens eine identifizierende Komponenteninformation tragendes Elektronikbauteil verbunden wird mit einer Hardware-Komponente, die ein eigenes, eine identifizierende Komponenteninformation tragendes Elektronikbauteil aufweist und beide Hardware-Komponenten zu einer neuen Einheit, insbesondere zu einer nicht ohne Zerstörung trennbaren Einheit versiegelt oder verplombt werden.

7. Verfahren nach einem der vorherigen Ansprüche, **dadurch gekennzeichnet, dass** ein Teil von Hardware-Komponenten (4,6) des Testsystems mittels eines ersten Netzwerkes (3), insbesondere mit einem ersten Bus an den Rechner (5.1) des Testsystems angeschlossen ist und ein Teil von Hardware-Komponenten (1,8) des Testsystems, insbesondere ein zu testendes Steuergerät (1) und/oder Echtlasten (8) mittels eines zweiten Netzwerkes (7), insbesondere mit einem zweiten Bus und einem die Netzwerke (3,7), insbesondere die Busse verbindenden Gateway (6), insbesondere ersten Gateway (6) an den Rechner (5.1) des Testsystems angeschlossen ist.

8. Verfahren nach Anspruch 7, **dadurch gekennzeichnet, dass** identifizierende Komponenteninformationen von an das zweite Netzwerk (7) angeschlossenen Hardware-Komponenten (1,8), insbesondere solchen Hardware-Komponenten, an denen zum Zweck der Bereitstellung einer identifizierenden Komponenteninformation ein Elektronikbauteil ohne Bedeutung für die Funktion der Hardware-Komponente während eines Test angeordnet ist, mittels einer jeweiligen Datenverbindung (9) ausgelesen werden, deren Daten mittels wenigstens eines Gateways (10), insbesondere zweiten Gateways (10) auf das zweite Netzwerk (7) aufgeschaltet werden.

9. Verfahren nach Anspruch 8, **dadurch gekennzeichnet, dass** die Datenverbindung (9) durch einen 1-Draht-Bus zwischen Elektronikbauteil und dem Gateway (10), insbesondere dem zweitem Gateway (10) ausgebildet wird.

10. Verfahren nach Anspruch 9, **dadurch gekennzeichnet, dass** mit wenigstens einem zweiten Gateway (10) die Daten von mehreren 1-Draht-Bussen (9) der Elektronikbauteile verschiedener Hardware-Komponenten (1,8), die physikalisch parallel an Ports des wenigstens einen zweiten Gateways (10) anliegen, umgesetzt werden in Daten, die an verschiedenen Adressen des zweiten Netzwerks (7) auslesbar sind, wobei jede der verschiedenen Adressen genau einem Port des wenigstens einen zweiten Gateways (10) zugeordnet ist, insbesondere wobei die Adressen in einer numerischen Reihenfolge der Ports geordnet sind.

11. Verfahren nach Anspruch 7, **dadurch gekennzeichnet, dass** identifizierende Komponenteninformationen von an das zweite Netzwerk (7) angeschlossenen Hardware-Komponenten (1,8), insbesondere solchen Hardware-Komponenten, an denen zum Zweck der Bereitstellung einer identifizierenden Komponenteninformation ein Elektronikbauteil ohne Bedeutung für die Funktion der Hardware-Komponente während eines Test angeordnet ist, mittels eines dritten, für die Simulation einer Testumgebung nicht genutzten Netzwerkes ausgelesen und in den Rechner (5.1) des Testsystems oder einen an das Testsystem angeschlossenen Steuer-Rechner (5.2) übertragen werden.

12. Verfahren nach einem der vorherigen Ansprüche, **dadurch gekennzeichnet, dass** als identifizierende Komponenteninformation eine elektronisch auslesbare Seriennummer eines Elektronikbauteils, insbesondere eine 64-Bit-Nummer verwendet wird.

## Claims

1. Method for performing an inventory of the hardware components (1, 4, 6, 8) connected to a controller test system, wherein the test system can be used to test controllers (1) in an environment that is simulated by the test system by means of a model and wherein the test system comprises at least one computer (5.1) and hardware components (1, 4, 6, 8) that are connected to one another by means of at least one network (3, 7), wherein at least one piece of component information digitally identifying the hardware component (1, 4, 6, 8) in a univocal manner is read from at least some of the hardware components (1, 4, 6, 8) and all identifying pieces of component information that are read are stored, **characterized in that** a piece of component information identifies the hardware component in a univocal manner in each case and is read from an electronic assembly that is not needed for the operation of the hardware component (1, 4, 6, 8) during a test and that is arranged on the hardware component (1, 4, 6, 8) for the purpose of providing an identifying piece of component information.

2. Method according to Claim 1, **characterized in that** the identifying pieces of component information are read by means of the computer (5.1) of the test system or by means of a control computer (5.2) that is connected to the test system.

3. Method according to either of the preceding claims, **characterized in that** the identifying pieces of component information that are read and stored describe a technical actual configuration of the test system, particularly in the form of a table, that is compared with a setpoint configuration, which was created and stored when the test system was designed, particularly by comparing the respective configuration entries, particularly wherein the comparison is performed by the computer (5.1) of the test system or a control computer (5.2) that is connected to the test system.

4. Method according to one of the preceding claims, **characterized in that** the actual and setpoint configurations, particularly a respective table comprising the configuration entries, take account of an identification of a hardware component (1, 4, 6, 8) that is associated with said hardware component in the network (3, 7) used, particularly that corresponds to a network or bus address of the network (3, 7) used and that, in the event of a communication by the hardware component (1, 4, 6, 8), is also sent via the network (3, 7), and a check is performed, by comparing actual and setpoint configurations on the basis of the identifying piece of component information and the identification, to determine whether installed hardware components (1, 4, 6, 8) are installed correctly in terms of technical characteristics of the hardware component (1, 4, 6, 8) and the installation location.

5. Method according to either of the preceding Claims 3 and 4, **characterized in that** a creation of the actual configuration and a comparison with the setpoint configuration are repeated, particularly at the execution time of a test, in particular cyclically or in communication pauses that occur on the network (3, 7) used.

6. Method according to one of the preceding claims, **characterized in that** a hardware component without an electronic assembly of its own carrying at least one identifying piece of component information is connected to a hardware component that has an electronic assembly of its own carrying an identifying piece of component information, and both hardware components are sealed or lead-sealed to form a new unit, particularly to form a unit that is not separable without destruction.

7. Method according to one of the preceding claims, **characterized in that** some hardware components (4, 6) of the test system are connected to the computer (5.1) of the test system by means of a first network (3), particularly with a first bus, and some hardware components (1, 8) of the test system, particularly a controller (1) to be tested and/or genuine loads (8), are connected to the computer (5.1) of the test system by means of a second network (7), particularly with a second bus and a gateway (6), particularly a first gateway (6), that connects the networks (3, 7), particularly the busses.

8. Method according to Claim 7, **characterized in that** identifying pieces of component information from hardware components (1, 8) connected to the second network (7), particularly hardware components on which an electronic assembly without significance for the operation of the hardware component during a test is arranged for the purpose of providing an identifying piece of component information, are read by means of a respective data link (9), the data of which are connected to the second network (7) by means of at least one gateway (10), particularly a second gateway (10).

9. Method according to Claim 8, **characterized in that** the data link (9) is formed by a 1-wire bus between electronic assembly and the gateway (10), particularly the second gateway (10).

10. Method according to Claim 9, **characterized in that** at least one second gateway (10) is used to convert the data from multiple 1-wire busses (9) of the electronic assemblies of different hardware components (1, 8) that are in physically parallel contact with ports of the at least one second gateway (10) into data that are readable at different addresses of the second network (7), wherein each of the different addresses is associated with precisely one port of the at least one second gateway (10), particularly wherein the addresses are organised in a numerical order of the ports.

11. Method according to Claim 7, **characterized in that** identifying pieces of component information from hardware components (1, 8) connected to the second network (7), particularly hardware components on which an electronic assembly without significance for the operation of the hardware component during a test is arranged for the purpose of providing an identifying piece of component information, are read by means of a third network, which is not used for simulating a test environment, and transmitted to the computer (5.1) of the test system or a control computer (5.2) that is connected to the test system.

12. Method according to one of the preceding claims, **characterized in that** the identifying piece of component information used is an electronically readable serial number of an electronic assembly, particularly a 64-bit number.

## Revendications

1. Procédé de réalisation d'un inventaire des composants matériels (1,4,6,8) raccordés à un système de test d'appareils de commande, dans lequel des appareils de commande (1) peuvent être testés à l'aide du système de test dans un environnement simulé par le système de test au moyen d'un modèle et dans lequel le système de test comprend au moins un calculateur (5.1) et des composants matériels (1,4,6,8) qui sont connectés les uns aux autres au moyen d'au moins un réseau (3,7), dans lequel au moins une information de composant identifiant numériquement de manière unique les composants matériels (1,4,6,8) est lue à partir d'au moins une partie des composants matériels (1,4,6,8), et toutes les informations de composants identifiantes lues sont mémorisées, **caractérisé en ce qu'**une information de composant identifie respectivement de manière unique les composants matériels et **en ce qu'**elle est lue à partir d'un composant électronique non exigé pendant un test pour la fonction du composant matériel (1,4,6,8), lequel composant électronique est disposé sur le composant matériel (1,4,6,8) aux fins de la fourniture d'une information de composant identifiante.

2. Procédé selon la revendication 1, **caractérisé en ce que** la lecture des informations de composants identifiantes s'effectue au moyen du calculateur (5.1) du système de test ou au moyen d'un calculateur de commande (5.2) raccordé au système de test.

3. Procédé selon l'une quelconque des revendications précédentes, **caractérisé en ce que** les informations de composants identifiantes lues et mémorisées décrivent une configuration technique effective du système de test, notamment sous la forme d'une table, laquelle configuration est comparée à une configuration nominale établie et mémorisée lors de la conception du système de test, notamment par comparaison des entrées de configuration respectives, notamment dans lequel la comparaison est effectuée par le calculateur (5.1) du système de test ou par un calculateur de commande (5.2) raccordé au système de test.

4. Procédé selon l'une quelconque des revendications précédentes, **caractérisé en ce qu'**il est tenu compte, dans les configurations effective et nominale, notamment dans une table respective comprenant les entrées de configuration, d'une identification d'un composant matériel (1,4,6,8), qui lui est associée dans le réseau (3,7) utilisé, qui correspond notamment à une adresse de réseau ou de bus du réseau (3,7) utilisé et qui est transmise lors d'une communication du composant matériel (1,4,6,8) par l'intermédiaire du réseau (3,7) et **en ce qu'**il est vérifié, par comparaison des configurations effective et nominale sur la base de l'information de composant identifiante et de l'identification, si des composants matériels (1,4,6,8) installés sont correctement installés du point de vue de la propriété technique du composant matériel (1,4,6,8) et de l'emplacement d'installation.

5. Procédé selon l'une quelconque des revendications 3 ou 4, **caractérisé en ce que** la détermination de la configuration effective et la comparaison à la configuration nominale sont répétées, notamment pendant l'exécution d'un test, notamment de manière cyclique ou au cours de pauses de communication se produisant sur le réseau (3,7) utilisé.

6. Procédé selon l'une quelconque des revendications précédentes, **caractérisé en ce qu'**un composant matériel est connecté sans aucun composant électronique qui lui est propre, portant au moins une information de composant identifiante, à un composant matériel qui comporte un composant électronique qui lui est propre, portant une information de composant identifiante et **en ce que** les deux composants matériels sont fermés hermétiquement ou scellés en une nouvelle unité, notamment en une unité ne pouvant pas être séparée sans destruction.

7. Procédé selon l'une quelconque des revendications précédentes, **caractérisé en ce qu'**une partie des composants matériels (4,6) du système de test est raccordée au calculateur (5.1) du système de test au moyen d'un premier réseau (3), notamment par un premier bus, et **en ce qu'**une partie des composants matériels (1,8) du système de test, notamment un appareil de commande (1) et/ou des charges réelles (8) à tester, est raccordée au calculateur (5.1) du système de test au moyen d'un second réseau (7), notamment par un second bus et par une passerelle (6), notamment une première passerelle (6), connectant les réseaux (3,7), notamment les bus.

8. Procédé selon la revendication 7, **caractérisé en ce que** des informations de composants identifiantes de composants matériels (1,8) raccordés au second réseau (7), notamment des composants matériels sur lesquels est disposé, aux fins de la fourniture d'une information de composant identifiante, un composant électronique sans importance pour la fonction dus composants matériel pendant un test, sont lues au moyen d'une connexion de données (9) respective, dont les données sont appliquées au moyen d'au moins une passerelle (10), notamment d'une seconde passerelle (10), au second réseau (7).

9. Procédé selon la revendication 8, **caractérisé en ce que** la connexion de données (9) est réalisée par un bus à 1 fil entre le composant électronique et la passerelle (10), notamment la seconde passerelle (10).

10. Procédé selon la revendication 9, **caractérisé en ce que**, à l'aide d'au moins une seconde passerelle (10), les données de plusieurs bus à 1 fil (9) des composants électroniques de différents composants matériels (1,8) qui sont adjacents de manière physiquement parallèle à des ports de l'au moins une seconde passerelle (10), sont transformées en des données qui peuvent être lues à différentes adresses du second réseau (7), dans lequel chacune des différentes adresses est associée à exactement un port de l'au moins une seconde passerelle (10), notamment dans lequel les adresses sont ordonnées dans un ordre numérique des ports.

11. Procédé selon la revendication 7, **caractérisé en ce que** des informations de composants identifiantes de composants matériels (1,8) raccordés au second réseau (7), notamment des composants matériels sur lesquels est disposé, aux fins de la fourniture d'une information de composant identifiante, un composant électronique sans importance pour la fonction du composant matériel pendant un test, sont lues au moyen d'un troisième réseau non utilisé pour la simulation d'un environnement de test et sont transmises dans le calculateur (5.1) du système de test ou dans un calculateur de commande (5.2) raccordé au système de test.

12. Procédé selon l'une quelconque des revendications précédentes, **caractérisé en ce qu'**un numéro de série lisible électroniquement d'un composant électronique, notamment un numéro à 64 bits, est utilisé en tant qu'information de composant identifiante.
